# EUROPÄISCHE PATENTSCHRIFT

(11) **EP 2 374 338 B1**
(45) Veröffentlichungstag und Bekanntmachung des Hinweises auf die Patenterteilung: **27.07.2016**
(21) Anmeldenummer: 09760852.5
(22) Anmeldetag: 25.11.2009
(51) Int. Cl.: H05K 3/30, H05K 3/34, H05K 3/36, H05K 5/00, H05K 7/14

(54) **ELEKTRISCHE SCHALTUNGSANORDNUNG, STEUERGERÄT UND VERFAHREN ZUM HERSTELLEN EINER ELEKTRISCHEN SCHALTUNGSANORDNUNG**
ELECTRICAL CIRCUIT ASSEMBLY, CONTROL DEVICE AND METHOD FOR PRODUCING AN ELECTRICAL CIRCUIT ASSEMBLY
CIRCUIT ÉLECTRIQUE, UNITÉ DE COMMANDE ET PROCÉDÉ DE PRODUCTION D'UN CIRCUIT ÉLECTRIQUE

(30) Priorität: 08.12.2008 DE 102008054385
(43) Veröffentlichungstag der Anmeldung: 12.10.2011
(73) Patentinhaber: Robert Bosch GmbH, 70442 Stuttgart (DE)
(72) Erfinder: LUHR, Volker, 71706 Markgroeningen (DE); SCHWEIKER, Markus-Alexander, 70193 Stuttgart (DE); KLOETZIG, Rene, 72762 Reutlingen (DE); VOETH, Andrea, 71282 Hemmingen (DE)
(86) Internationale Anmeldenummer: PCT/EP2009/065821
(87) Internationale Veröffentlichungsnummer: WO 2010/076099

(56) Entgegenhaltungen:
- EP-A1- 0 917 992
- EP-A2- 1 909 545
- WO-A1-2009/056422
- DE-A1- 2 338 499
- DE-A1- 2 752 665
- US-A- 3 624 587
- US-A- 5 387 816
- US-A1- 2007 224 870

## Beschreibung

Die Erfindung betrifft eine elektrische Schaltungsanordnung, insbesondere für ein Steuergerät eines Kraftfahrzeugs, mit einer ersten Leiterplatine, mindestens einer zweiten Leiterplatine und mindestens einer Halterung zum Halten der zweiten Leiterplatine an der ersten Leiterplatine unter Herstellung eines elektrischen Kontakts zwischen der ersten und der zweiten Leiterplatine. Die Erfindung betrifft auch ein Steuergerät mit mindestens einer elektrischen Schaltungsanordnung. Die Erfindung betrifft weiterhin ein Verfahren zum Herstellen einer elektrischen Schaltungsanordnung.

### Stand der Technik

Elektrische Schaltungsanordnungen der eingangs genannten Art sind aus dem Stand der Technik bekannt. Beispielsweise beschreibt die DE 692 10 365 T2 einen der Halterung entsprechenden elektrischen Verbinder, mit dem beispielsweise gedruckte Schaltplatinen, also Leiterplatinen, elektrisch miteinander verbunden werden können. Dabei ist die erste Leiterplatine eine Speicherkontrollplatine und die zweite Leiterplatine eine Single-in-line Speicherbaugruppe (SIMM). Die Speicherbaugruppe soll mittels dem elektrischen Verbinder senkrecht bezüglich der Oberfläche der Speicherkontrollplatine angeordnet sein. In einem Schlitz des elektrischen Verbinders sind Kontaktanschlüsse angeordnet, mit welchen die Speicherbaugruppe in eingesetztem Zustand elektrisch verbunden sind. Über die Kontaktanschlüsse ist der elektrische Kontakt zwischen der Speicherbaugruppe und der Speicherkontrollplatine hergestellt. Bei dieser Anordnung ist vorgesehen, den elektrischen Verbinder fest mit der Speicherkontrollplatine zu verbinden, während die Speicherbaugruppe in den Verbinder eingesetzt und auch wieder aus diesem entnommen werden kann. Es ist also vorgesehen, dass der elektrische Verbinder zum Wechseln der Speicherbaugruppe ausgelegt ist, während er stets fest mit der Speicherkontrollplatine verbunden bleibt. Häufig ist es jedoch wünschenswert, insbesondere bei Steuergeräten für Kraftfahrzeuge, gleichzeitig mehrere zweite Leiterplatinen an der ersten Leiterplatine anzuordnen und den elektrischen Kontakt zwischen der ersten und den zweiten Leiterplatinen herzustellen. Auch soll häufig die zweite Leiterplatine bereits in einem Gehäuse der elektrischen Schaltungsanordnung verbaut sein, bevor die erste Leiterplatine in dieses eingesetzt wird. Aus diesem Grund ist es notwendig, die zweite Leiterplatine mit einer ausreichenden mechanischen Festigkeit zu versehen und überdies mit einer Halterung auszustatten, mit welcher sie ortsfest in dem Gehäuse angeordnet werden kann, um zuverlässig den elektrischen Kontakt zwischen der ersten und der zweiten Leiterplatine herstellen zu können, sobald erstere in das Gehäuse eingesetzt wird. Das bedeutet, dass in vielen Fällen keine dauerhafte Verbindung zwischen der ersten Leiterplatine und der Halterung und/oder der zweiten Leiterplatine hergestellt werden soll.

Aus der Offenlegungsschrift EP0917992 A1 ist ein Steuermodul für den Innenraum eines Kraftfahrzeuges bekannt. Das Steuermodul weist dabei ein Gehäuse auf sowie wenigstens eine Leistungskarte und wenigstens eine Steuerungskarte, die in dem Gehäuse angeordnet sind. Das Gehäuse besteht aus zwei Gehäusehälften, die aneinander verschlossen und um ein Gelenkband angelenkt sind, mit dem sie einstückig ausgeführt sind. Eine der Gehäusehälften weist Aufnahmen für Zungen und/oder Steckbuchsen auf. Die Steuerungskarte ist in etwa senkrecht im Verhältnis zur Leistungskarte erstreckt, unabhängig davon, ob die Gehäusehälften aneinander verschlossen sind oder nicht.

### Offenbarung der Erfindung

Wie die aus dem Stand der Technik bekannten elektrischen Schaltungsanordnungen weist die elektrische Schaltungsanordnung mit den in Anspruch 1 genannten Merkmalen den Vorteil auf, dass sie die Festigkeit der zweiten Leiterplatine erhöht, eine Befestigung derselben in einem Gehäuse ermöglicht. Dies ist dadurch erreicht, indem die zweite Leiterplatine an der Halterung vormontiert ist und die aus zweiter Leiterplatine und Halterung bestehende vormontierte Einheit mit der ersten Leiterplatine verbunden ist, wobei die Halterung und die zweite Leiterplatine quer, insbesondere rechtwinklig, zu der ersten Leiterplatine angeordnet sind. Es wird also nicht, wie bei noch anderen aus dem Stand der Technik bekannten elektrischen Schaltungsanordnungen, zunächst die Halterung an der ersten Leiterplatine befestigt und anschließend die zweite Leiterplatine in die Halterung eingesetzt. Es ist vielmehr vorgesehen, dass zunächst die zweite Leiterplatine mit der Halterung verbunden wird, sodass die vormontierte Einheit vorliegt. Die Halterung dient somit der Erhöhung der Festigkeit der zweiten Leiterplatine beziehungsweise der Befestigung der zweiten Leiterplatine an einem Gehäuse, an oder in welchem die elektrische Schaltungsanordnung vorgesehen ist. Anschließend wird die aus zweiter Leiterplatine und Halterung bestehende vormontierte Einheit mit der ersten Leiterplatine verbunden. Dabei wird der elektrische Kontakt zwischen der ersten und der zweiten Leiterplatine hergestellt. Sowohl die Halterung als auch die zweite Leiterplatine sollen quer zu der ersten Leiterplatine angeordnet sein. Vorteilhafterweise ist eine rechtwinklige Anordnung vorgesehen. Die Befestigung der vormontierten Einheit an der ersten Leiterplatine kann mittels der zweiten Leiterplatine, der Halterung oder beiden vorgesehen sein. Beispielsweise können Kontaktelemente der zweiten Leiterplatine mit der ersten Leiterplatine verbunden werden, wobei die Halterung der Abstützung auf der ersten Leiterplatine dient. Der elektrische Kontakt zwischen der ersten und der zweiten Leiterplatine kann sowohl unmittelbar als auch mittelbar hergestellt sein. In ersterem Fall sind Kontaktelemente der zweiten Leiterplatine mit Kontaktelementen der ersten Leiterplatine verbunden, während in letzterem Fall die Halterung ebenfalls Kontaktelemente aufweist, die mit den Kontaktelementen sowohl der ersten als auch der zweiten Leiterplatinen verbunden sind.

Kennzeichnend für die Erfindung ist, dass der elektrische Kontakt zwischen der ersten und der zweiten Leiterplatine unmittelbar und/oder über die Halterung hergestellt ist. Nach dem Verbinden der vormontierten Einheit mit der ersten Leiterplatine kann also eine elektrische Verbindung direkt zwischen der ersten und zweiten Leiterplatine vorliegen_{.} Dazu weisen beispielsweise sowohl die erste als auch die zweite Leiterplatine Kontaktelemente auf, welche nach dem Verbinden den elektrischen Kontakt ausbilden. Es kann auch vorgesehen sein, dass weitere Kontaktelemente an/in der Halterung vorgesehen sind, die sowohl mit Kontaktelementen der ersten als auch mit Kontaktelementen der zweiten Leiterplatine in Verbindung treten und so den elektrischen Kontakt mittelbar über die Halterung herstellen. Der elektrische Kontakt zwischen der zweiten Leiterplatine und der Halterung kann dabei bereits nach dem Vormontieren der vormontierten Einheit gebildet sein, während der elektrische Kontakt zu der ersten Leiterplatine erst mit dem Verbinden der vormontierten Einheit mit der ersten Leiterplatine zustande kommt.

Des Weiteren sieht die Erfindung vor, dass der Kontakt über die Halterung über mindestens ein Kontaktelement hergestellt ist. An oder in der Halterung ist also mindestens ein Kontaktelement vorgesehen, welches nach Vormontieren und Verbinden der vormontierten Einheit mit der ersten Leiterplatine sowohl einen elektrischen Kontakt mit der ersten als auch der zweiten Leiterplatine aufweist. Somit stehen dann auch die erste und die zweite Leiterplatine miteinander in elektrischer Verbindung.

Ferner sieht die Erfindung vor, dass das Kontaktelement die erste Leiterplatine mittels mindestens eines Federelements oder mindestens eines Einpresspins und die zweite Leiterplatine mittels mindestens eines Einpresspins kontaktiert. Der elektrische Kontakt zu der zweiten Leiterplatine ist also mittels des mindestens einen Einpresspins hergestellt. Der Einpresspin kann dabei so ausgelegt sein, dass er gleichzeitig zum Halten der zweiten Leiterplatine an der Halterung dient, über ihn also die Vormontage realisiert ist. Zur Kontaktierung der ersten Leiterplatine weist die Halterung mindestens ein Federelement, beispielsweise ein S-Federelement, oder mindestens einen Einpresspin auf. Das Federelement gewährleistet dabei eine einfache Demontage der Halterung von der ersten Leiterplatine, soll die Verbindung zwischen diesen gelöst werden. Sowohl das Federelement als auch der Einpresspin können aus Gold bestehen beziehungsweise Gold aufweisen, das heißt vergoldet sein.

Zusätzlich ist die Erfindung derart, dass als Rastverbindungselemente ausgebildete Halteelemente (16) zum Halten der zweiten Leiterplatine (3) an der Halterung (4) vorgesehen sind, wobei die Halterung (4) Einschuböffnungen zur rastenden Aufnahme der Halteelemente (16) aufweist.

Eine Weiterbildung der Erfindung sieht vor, dass die vormontierte Einheit mit der ersten Leiterplatine lösbar verbunden ist. Es muss somit keine dauerhafte Verbindung zwischen der vormontierten Einheit, das heißt der zweiten Leiterplatine und/oder der Halterung, zu der ersten Leiterplatine vorliegen. Es ist vielmehr vorgesehen, dass die vormontierte Einheit nach erfolgter Verbindung mit der ersten Leiterplatine von dieser wieder lösbar ist.

Eine Weiterbildung der Erfindung sieht vor, dass die Verbindung zwischen der ersten Leiterplatine und der Halterung und/oder die Befestigung der zweiten Leiterplatine an der Halterung mittels Warmverstemmen, Verschrauben, Verclipsen oder Einpressen hergestellt ist. Sowohl für die Verbindung zwischen der ersten Leiterplatine und der Halterung und der Befestigung der zweiten Leiterplatine an der Halterung können Verbindungen vorgesehen sein, die lösbar- beispielsweise Verschrauben, Verclipsen oder Einpressen - oder dauerhaft ausgelegt sind - beispielsweise Warmverstemmen. Dabei ist das Material der ersten und der zweiten Leiterplatine und der Halterung entsprechend vorgesehen.

Eine Weiterbildung der Erfindung sieht vor, dass die Halterung ein Druckgussbauteil ist. Besonders vorteilhaft und kostengünstig in der Herstellung ist die Halterung, wenn sie als Druckgussbauteil ausgebildet ist. Bei der Herstellung im Druckgussverfahren können bereits Halteelemente der Halterung mit ausgebildet werden. Auf diese Weise kann die Halterung in lediglich einem Herstellungsschritt hergestellt sein.

Eine Weiterbildung der Erfindung sieht vor, dass die Halterung Aluminium, Zink oder Magnesium oder einen Kunststoff aufweist. Die Halterung kann aus Aluminium, Zink oder Magnesium hergestellt sein oder diese Stoffe aufweisen, beispielsweise in Form einer Legierung. Auch kann die Halterung aus einem Kunststoff gefertigt sein. Diese Materialien sind besonders vorteilhaft im DruckgussVerfahren zu verarbeiten. Es ist vorteilhaft, wenn die Materialien eine gute Wärmeleitfähigkeit aufweisen, damit eventuell an der zweiten Leiterplatine anfallende Wärme von dieser abgeführt werden kann. Bei entsprechender Materialwahl kann die Halterung also auch als Kühlvorrichtung für die zweite Leiterplatine dienen.

Eine Weiterbildung der Erfindung sieht ein Gehäuse vor, in welchem die erste Leiterplatine, die zweite Leiterplatine und/oder die Halterung zumindest bereichsweise angeordnet sind. Dabei können beispielsweise eine oder mehrere zweite Leiterplatinen mit Halterung in dem Gehäuse angeordnet und anschließend mit der ersten Leiterplatine verbunden werden. Andererseits kann auch zuerst die erste Leiterplatine in dem Gehäuse befestigt werden und anschließend die zweite Leiterplatine in dieses eingebracht werden. Es ist dabei nicht notwendig, dass die erste Leiterplatine, die zweite Leiterplatine und/oder die Halterung vollständig in dem Gehäuse angeordnet sind. Vielmehr können sie auch bereichsweise außerhalb des Gehäuses vorgesehen sein. Beispielsweise kann das Gehäuse Ausnehmungen aufweisen, durch welche die zweite Leiterplatine zusammen mit der Halterung in dieses eingebracht und damit mit der ersten Leiterplatine verbunden werden. Es kann jedoch auch vorgesehen sein, dass das Gehäuse die erste Leiterplatine, die zweite Leiterplatine und die Halterung vollständig ummantelt und dabei insbesondere wasserdicht ausgebildet ist.

Eine Weiterbildung der Erfindung sieht vor, dass die Halterung zusammen mit der zweiten Leiterplatine an/in dem Gehäuse befestigt ist. Es kann also zunächst die zweite Leiterplatine zusammen mit der Halterung in dem Gehäuse angeordnet sein. Dabei muss noch keine Verbindung beziehungsweise kein elektrischer Kontakt zu der ersten Leiterplatine vorliegen. Dieser wird erst zu einem späteren Zeitpunkt hergestellt.

Eine Weiterbildung der Erfindung sieht vor, dass die vormontierte Einheit mittels Verschrauben, Verklemmen oder Kleben an/in dem Gehäuse befestigt ist. Die Halterung mit daran vormontierter zweiter Leiterplatine, also die vormontierte Einheit, kann auf verschiedene Arten an dem Gehäuse befestigt sein. Vorgesehen sind beispielsweise lösbare Verbindungen, wie Verschrauben oder Verklemmen, aber auch dauerhafte Verbindungen, wie beispielsweise Kleben. Die Befestigung kann sowohl zwischen dem Gehäuse und der Halterung als auch zwischen dem Gehäuse und der zweiten Leiterplatine oder beiden vorliegen.

Eine Weiterbildung der Erfindung sieht vor, dass mindestens zwei Halterungen vorgesehen sind, die unter einem Winkel zueinander angeordnet sind. Die mindestens zwei Halterungen können dabei beispielsweise als Winkelelement ausgeführt sein. Das bedeutet, dass die Halterungen entweder über ein Halteelement miteinander verbunden oder einstückig ausgeführt sind. Vorzugsweise sind die Halterungen dabei um ihre Hochachse gegeneinander verkippt. Der Winkel ist somit ungleich 0°, vorzugsweise gleich 90°. Die Halterungen können entweder über das Halteelement miteinander verbunden sein oder Verbindungselemente aufweisen, mit welchen sie aneinander befestigt werden können.

Eine Weiterbildung der Erfindung sieht vor, dass der unmittelbare Kontakt mittels Semiflexverbindung, mindestens einem Einpresspin, mindestens einem Felement, einem Leiterplatinenverbinder und/oder Löten hergestellt ist. Auch der elektrische Kontakt ist also sowohl über lösbare als auch über unlösbare Verbindungen vorgesehen. Ein Beispiel für eine lösbare Verbindung ist das mindestens eine Federelement, beispielsweise ein S-Federelement, ein Beispiel für eine unlösbare das Löten. Soll die vormontierte Einheit vor der ersten Leiterplatine in dem Gehäuse angeordnet sein, so empfiehlt sich das Herstellen des unmittelbaren Kontakts über den mindestens einen Einpresspin beziehungsweise das mindestens eine Federelement. Diese Verbindungen sind durch einfaches Einpressen beziehungsweise Aufsetzen der ersten Leiterplatine auf die Kontaktelemente der zweiten Leiterplatine herstellbar.

Die Erfindung betrifft ferner ein Steuergerät mit mindestens einer elektrischen Schaltungsanordnung gemäß den vorstehenden Ausführungen.

Die Erfindung betrifft auch ein Verfahren zum Herstellen einer elektrischen Schaltungsanordnung, insbesondere gemäß den vorstehenden Ausführungen, wobei die Schaltungsanordnung über eine erste Leiterplatine, mindestens eine zweite Leiterplatine und mindestens eine Halterung zum Halten der zweiten Leiterplatine an der ersten Leiterplatine unter Herstellung eines elektrischen Kontakts zwischen der ersten und der zweiten Leiterplatine verfügt. Dabei ist vorgesehen, dass die zweite Leiterplatine an der Halterung vormontiert wird und dass die aus zweiter Leiterplatine und Halterung bestehende vormontierte Einheit mit der ersten Leiterplatine verbunden wird, wobei die Halterung und die zweite Leiterplatine quer, insbesondere rechtwinklig zu der ersten Leiterplatine angeordnet werden.

Die Erfindung wird im Folgenden anhand der in der Zeichnung dargestellten Ausführungsbeispiele näher erläutert, ohne dass eine Beschränkung der Erfindung erfolgt. Es zeigen:
- Figur 1: eine elektrische Schaltungsanordnung mit einer ersten Leiterplatine, einer zweiten Leiterplatine und einer Halterung,
- Figur 2: eine Detailansicht einer vormontierten Einheit bestehend aus der Halterung und der zweiten Leiterplatine,
- Figur 3: eine Anordnung aus zwei miteinander verbundenen Halterungen, die unter einem Winkel zueinander angeordnet sind,
- Figur 4: ein Gehäuse der elektrischen Schaltungsanordnung, worin zwei vormontierte Einheiten vorgesehen sind,
- Figur 5: eine Ansicht des Gehäuses mit zwei darin angeordneten vormontierten Einheiten sowie der ersten, in das Gehäuse einzusetzenden, Leiterplatine,
- Figur 6: eine Explosionszeichnung der elektrischen Schaltungsanordnung mit dem Gehäuse, den vormontierten Einheiten, der ersten Leiterplatine und zum Verschließen des Gehäuses verwendeten Schrauben,
- Figur 7: eine Detailansicht der Halterung, wobei zum Kontaktieren der zweiten Leiterplatine Einpresspins und zum Kontaktieren der ersten Leiterplatine S-Federelemente vorgesehen sind,
- Figur 8: die aus Figur 7 bekannte Halterung in einer Ansicht von unten, sodass Kontaktflächen für die S-Federelemente erkennbar sind, und
- Figur 9: eine Halterung, wobei sowohl zur Kontaktierung der ersten als auch der zweiten Leiterplatine Einpresspins vorgesehen sind.

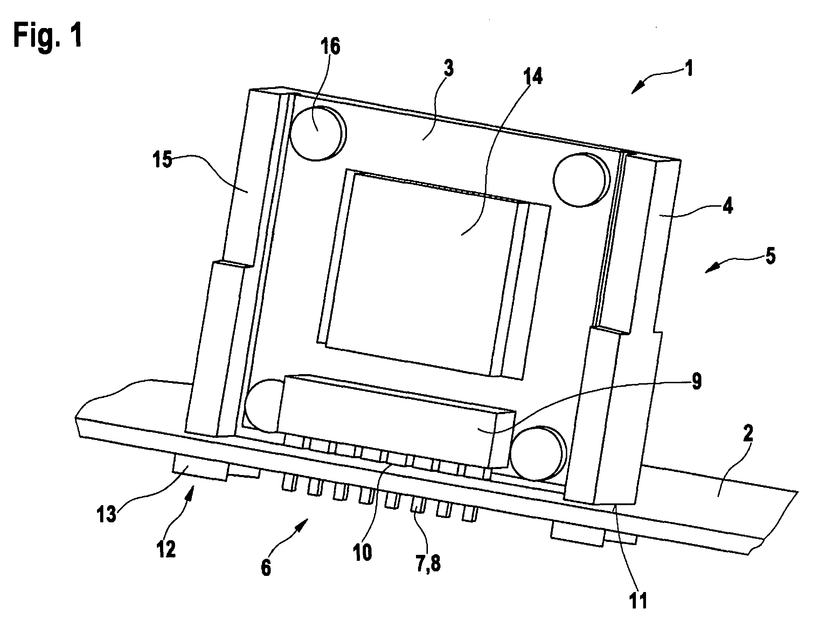

Die Figur 1 zeigt eine elektrische Schaltungsanordnung 1, die aus einer ersten Leiterplatine 2, einer zweiten Leiterplatine 3 und einer Halterung 4 besteht. Die zweite Leiterplatine 3 ist an der Halterung 4 vormontiert, woraus sich eine vormontierte Einheit 5 ergibt. Die zweite Leiterplatine 3 ist dabei beispielsweise mittels Warmverstemmen, Verschrauben, Verclipsen oder Einpressen an der Halterung 4 befestigt. Sowohl die zweite Leiterplatine 3 als auch die Halterung 4 sind rechtwinklig zu der ersten Leiterplatine 2 angeordnet, das heißt, dass eine Hochachse der Halterung 4 senkrecht auf der ersten Leiterplatine 2 steht. In dem in Figur 1 dargestellten Beispiel ist ein elektrischer Kontakt 6 unmittelbar zwischen der ersten Leiterplatine 2 und der zweiten Leiterplatine 3 über Kontaktelemente 7 hergestellt. Die Kontaktelemente sind als Einpresspins 8 ausgeführt und mittels eines Kontaktelementhalters 9 so angeordnet, dass bei einer Verbindung der vormontierten Einheit 5 mit der ersten Leiterplatine 2 die Einpresspins 8 durch Kontaktausnehmungen 10 der ersten Leiterplatine 2 gedrückt werden können. Die Halterung 4 bildet an ihrer mit der ersten Leiterplatine 2 in Kontakt tretenden Seite Kontaktflächen 11 aus, die der Stabilisierung der zweiten Leiterplatine 3 dienen. Nach dem Verbinden der vormontierten Einheit 5 mit der ersten Leiterplatine 2 sorgen die Kontaktflächen 11 dafür, dass kein Verkippen der vormontierten Einheit 5 beziehungsweise der zweiten Leiterplatine 3 auftreten kann. Die Verbindung zwischen der vormontierten Einheit 5 und der ersten Leiterplatine 2 kann beispielsweise über die Einpresspins 8 hergestellt sein.

Zusätzlich sind in dem in Figur 1 dargestellten Beispiel jedoch Rastvorrichtungen 12 vorgesehen, die mit Rastköpfen 13 Rastausnehmungen (hier nicht sichtbar) der ersten Leiterplatine 2 beim Verbinden der vormontierten Einheit 5 mit der ersten Leiterplatine 2 durchgreifen und eine Rastverbindung zwischen der vormontierten Einheit 5 und der ersten Leiterplatine 2 herstellen. Auf der zweiten Leiterplatine 3 ist mindestens ein elektrisches Bauelement 14 vorgesehen, welches elektrisch mit dieser verbunden ist, also in elektrischem Kontakt zu der ersten Leiterplatine 2 stehen kann. Die Halterung 4 besteht im Wesentlichen aus zwei miteinander verbundenen Haltearmen 15, die parallel zu der zweiten Leiterplatine 3 verlaufen. Die Rastvorrichtungen 12 sind an den Haltearmen 15 vorgesehen. Gleichzeitig können die Haltearme 15 auch mindestens einen Einschub (hier nicht dargestellt) für die zweite Leiterplatine 3 aufweisen, in welche diese zur Vormontage eingeschoben werden kann. In dem dargestellten Beispiel erfolgt die Vormontage jedoch mittels Halteelementen 16, die beispielsweise analog zu den Rastvorrichtungen 12 ausgebildet sein können und die zweite Leiterplatine 3 an der Halterung 4 halten. Sowohl die Rastvorrichtungen 12 als auch die Halteelemente 16 können beispielsweise als in der Halterung 4 verrastbare Rastverbindungselemente ausgebildet sein. Das bedeutet, dass sie in dem in die Halterung 4 eingreifenden Teil Rastelemente aufweisen, die sie in diesem nach einem Einstecken sicher halten.

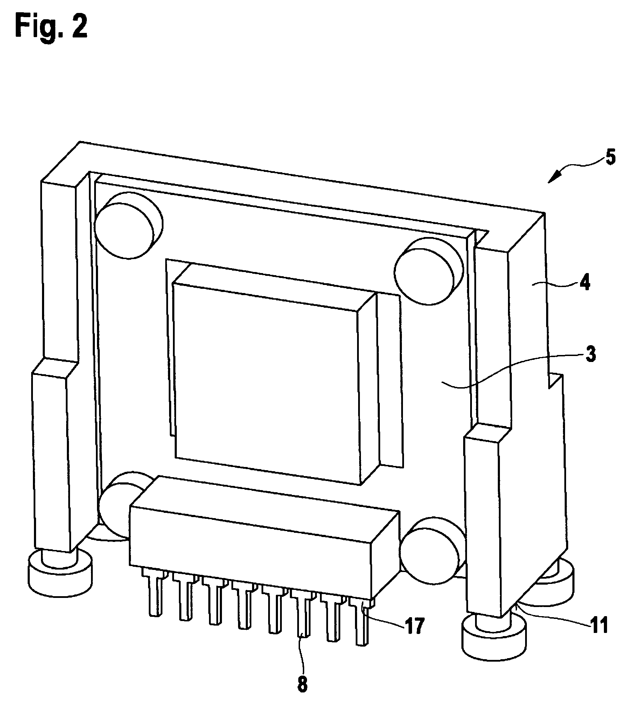

Die Figur 2 zeigt die vormontierte Einheit 5 bestehend aus Halterung 4 und zweiter Leiterplatine 3 ohne die in Figur 1 dargestellte erste Leiterplatine 2. Deutlich ist erkennbar, dass die Einpresspins 8 einen Kragen 17 aufweisen, der zusammen mit der Kontaktfläche 11 der Einschubbegrenzung bei dem Verbinden der vormontierten Einheit 5 mit der ersten Leiterplatine 2 dient. Bei dem Verbinden kann also sowohl die Kontaktfläche 11 als auch der Kragen 17 mit der ersten Leiterplatine 2 in Verbindung treten.

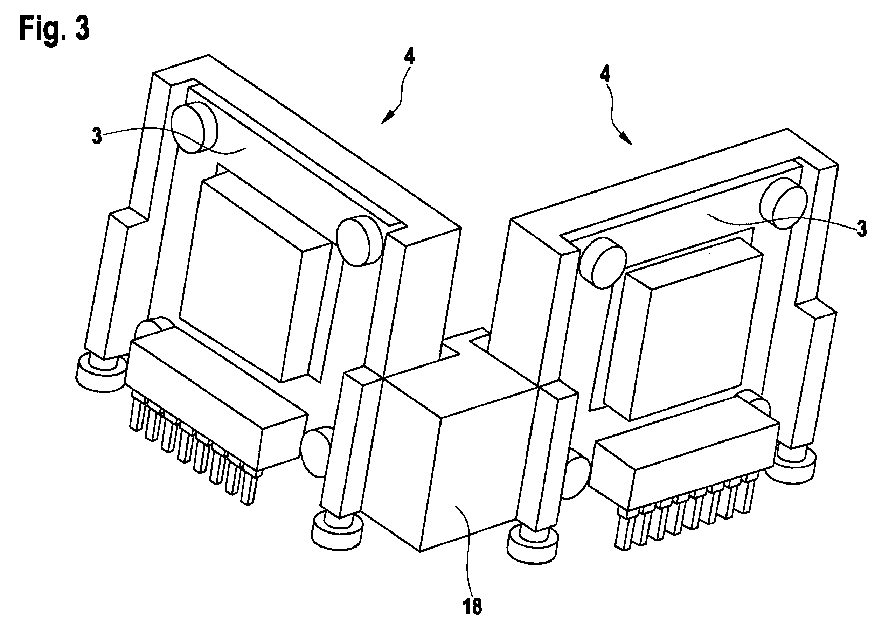

Die Figur 3 zeigt zwei Halterungen 4, an der jeweils eine zweite Leiterplatine 3 vormontiert ist. Die Halterungen 4 sind senkrecht zueinander angeordnet und mittels eines Verbindungselements 18 miteinander - insbesondere lösbar - verbunden. Die mittels des Verbindungselements 18 miteinander verbundenen Halterungen 4 können also gemeinsam mit der ersten Leiterplatine 2 verbunden werden. Alternativ kann auch vorgesehen sein, dass die Halterungen 4 ohne das Verbindungselement 18, also unmittelbar, aneinander befestigt sind. Beispielsweise können die Halterungen 4 einstückig ausgeführt sein, insbesondere während eines gemeinsamen Herstellungsprozesses.

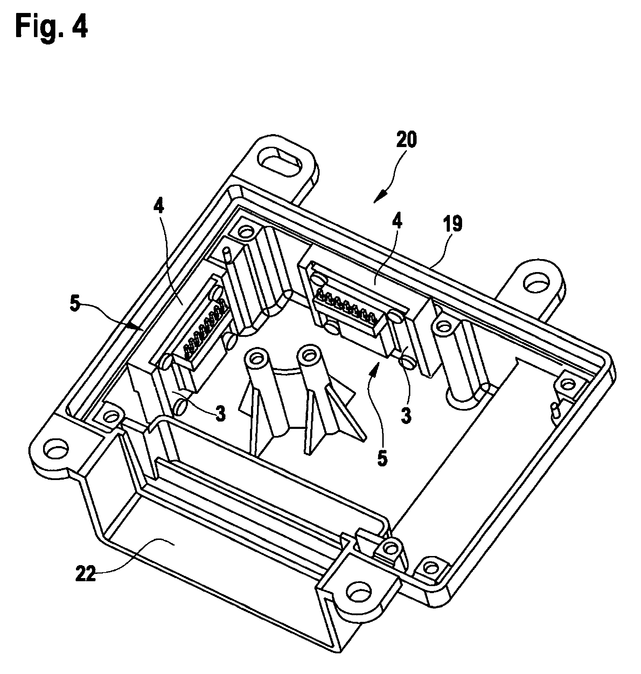

Die Figur 4 zeigt einen ersten Teil 19 eines Gehäuses 20, in welchem zwei Halterungen 4 mit darin vormontierter zweiter Leiterplatine 3 angeordnet sind. Der erste Teil 19 des Gehäuses 20 ist als Schale ausgebildet und kann mittels einem zweiten Teil 21 (hier nicht dargestellt) nach dem Verbinden der vormontierten Einheiten 5 mit der ersten Leiterplatine 2 (hier ebenfalls nicht dargestellt) verschlossen werden. In einer Frontseite des Gehäuses 20 ist eine Ausnehmung 22 vorgesehen, in welcher beispielsweise eine Steckerleiste der ersten Leiterplatine 2 angeordnet werden kann. Die vormontierten Einheiten 5 sind in dem dargestellten Beispiel mittels Verklemmen in dem Gehäuse 20 befestigt.

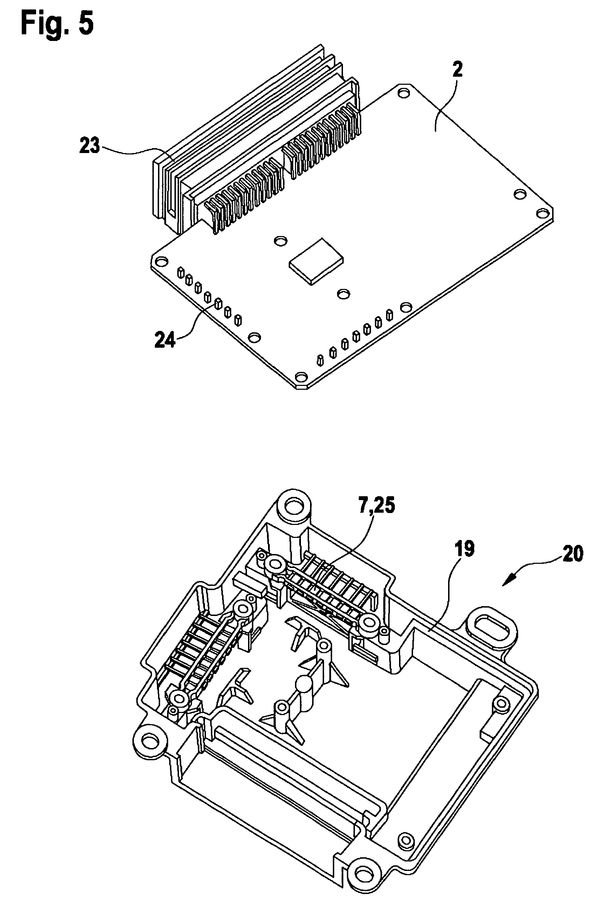

Die Figur 5 zeigt sowohl den ersten Teil 19 des Gehäuses 20 als auch die erste Leiterplatine 2 mit darin angebrachter Steckerleiste 23. Die erste Leiterplatine 2 kann so in dem Gehäuse 20 angeordnet werden, dass die Steckerleiste 23 in der Ausnehmung 22 zu liegen kommt. Dabei wird ein elektrischer Kontakt zwischen Kontaktelementen 24 der ersten Leiterplatine 2 und den Kontaktelementen 7, die hier als Kontaktflächen 25 für S-Federelemente ausgebildet sind, hergestellt. Somit sind nach dem Platzieren der ersten Leiterplatine 2 in dem Gehäuse 20 die erste Leiterplatine 2 und die zweite Leiterplatine 3 elektrisch miteinander verbunden. Durch das Herstellen des elektrischen Kontakts 6 mittels der S-Federelemente beziehungsweise der Kontaktflächen 25 - die eine lösbare Verbindung bilden - kann die erste Leiterplatine 2 einfach wieder aus dem Gehäuse 20 entnommen werden.

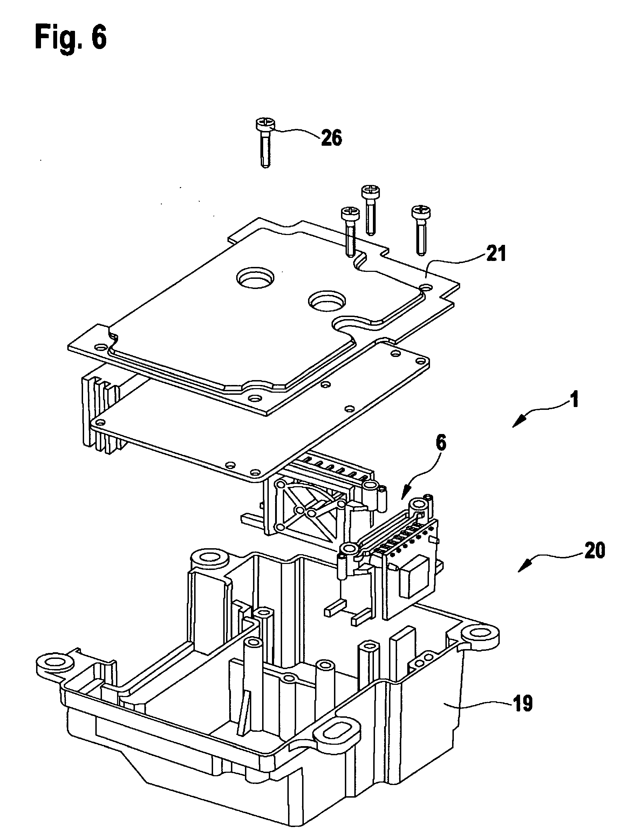

Die Figur 6 zeigt eine Explosionsdarstellung der Schaltungsanordnung 1. Es ist zu erkennen, dass das Gehäuse 20 aus einem ersten Teil 19 und einem zweiten Teil 21 besteht, die mittels Schrauben 26 miteinander verbunden sind. In dem ersten Teil 19 des Gehäuses 20 werden die vormontierten Einheiten 5 - bestehend jeweils aus Halterung 4 und zweiter Leiterplatine 3 - angeordnet, anschließend die erste Leiterplatine 2 aufgelegt und das Gehäuse 20 verschlossen. In zusammengebautem Zustand, also bei verschlossenem Gehäuse 20, wird die erste Leiterplatine 2 auf die vormontierten Einheiten 5 gedrückt, womit der elektrische Kontakt 6 hergestellt ist.

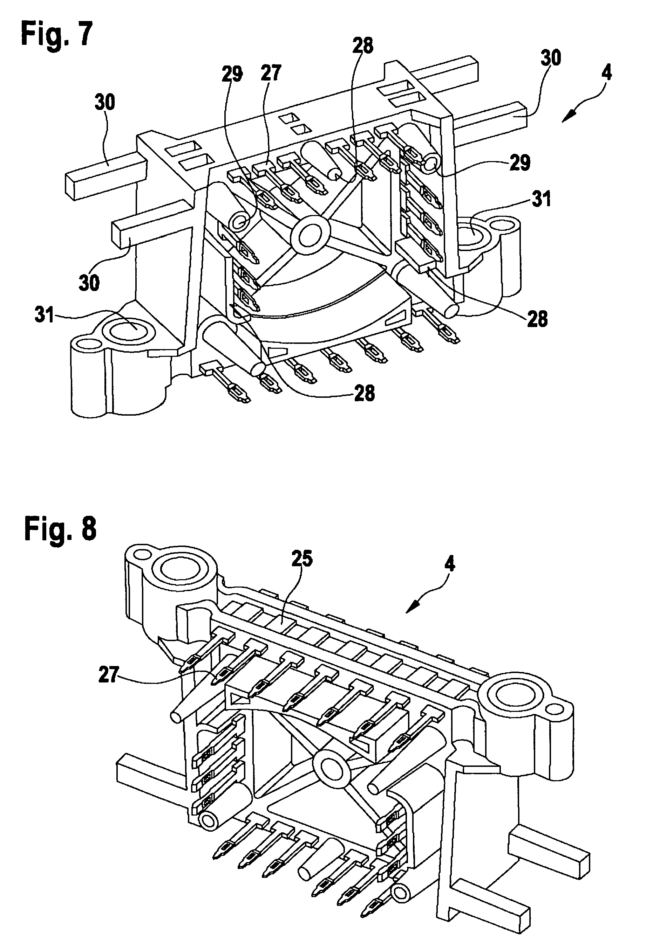

Die Figur 7 zeigt eine Halterung 4, ohne vormontierte zweite Leiterplatine 3. Die Halterung 4 verfügt über Einpresspins 27 zur Kontaktierung und zum Halten der zweiten Leiterplatine 3. Ebenso sind Auflageflächen 28 vorgesehen, auf welchen die zweite Leiterplatine 3 nach der Vormontage aufliegt. Ebenso sind Einschuböffnungen 29 zur rastenden Aufnahme der Halteelemente 16 vorgesehen. Die Halteelemente 16 werden nach dem Vormontieren der zweiten Leiterplatine 3 auf der Halterung 4 in die Einschuböffnungen 29 rastend eingebracht. An der Halterung 4 sind Führungsnasen 30 vorgesehen, die eine genaue Positionierung bei einem Einbringen der Halterung 4 in das Gehäuse 20 erlauben. Die in Figur 7 dargestellte Halterung 4 weist Buchsen 31 auf, welche zur Befestigung der Halterung 4 an der ersten Leiterplatine 2 von Schrauben (nicht dargestellt) durchgreifbar sind. Auf diese Weise ist über die Führungsnasen 30 sowohl die genaue Positionierung als auch mittels der Buchsen 31 eine sichere und lösbare Befestigung an der ersten Leiterplatine 2 gegeben.

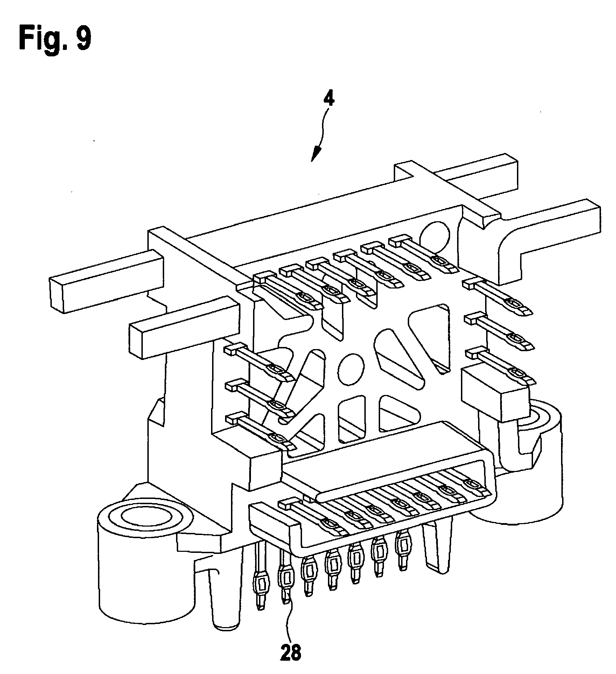

Die Figur 8 zeigt die aus Figur 7 bekannte Halterung 4 in einer Ansicht von unten. Deutlich erkennbar sind hier Kontaktflächen 25 für die S-Federelemente, über welche der elektrische Kontakt 6 zu der ersten Leiterplatine 2 hergestellt werden soll. Die Kontaktflächen 25 für die S-Federelemente sind elektrisch mit den Einpresspins 27 verbunden, sodass der elektrische Kontakt 6 zwischen erster Leiterplatine 2 und zweiter Leiterplatine 3 über die Halterung 4 hergestellt ist. Die Figur 9 zeigt eine alternative Ausführungsform der aus Figur 7 und 8 bekannten Halterung 4. Im Unterschied zu diesen weist die hier dargestellte Halterung 4 zur Kontaktierung der ersten Leiterplatine 2 keine Kontaktflächen 25 für S-Federelemente, sondern Einpresspins 28 auf. Im Unterschied zu den in den Figuren 1 und 2 dargestellen Halterungen 4 wird somit auch hier der elektrische Kontakt 6 nicht direkt zwischen erster Leiterplatine 2 und zweiter Leiterplatine 3 hergestellt, sondern über die Halterung 4 beziehungsweise die Einpresspins 28. Für die weiteren Eigenschaften der hier dargestellten Halterung 4 sei auf die Ausführungen zu den Figuren 7 und 8 verwiesen.

## Patentansprüche

1. Elektrische Schaltungsanordnung (1) für ein Steuergerät eines Kraftfahrzeugs, mit einer ersten Leiterplatine (2), mindestens einer zweiten Leiterplatine (3) und mindestens einer Halterung (4) zum Halten der zweiten Leiterplatine (3) an der ersten Leiterplatine (2) unter Herstellung eines elektrischen Kontakts (6) zwischen der ersten (2) und der zweiten (3) Leiterplatine, wobei die zweite Leiterplatine (3) an der Halterung (4) vormontiert ist und die aus zweiter Leiterplatine (3) und Halterung (4) bestehende vormontierte Einheit (5) mit der ersten Leiterplatine (2) verbunden ist, wobei die Halterung (4) und die zweite Leiterplatine (3) quer, insbesondere rechtwinklig, zu der ersten Leiterplatine (2) angeordnet sind, **dadurch gekennzeichnet, dass** der elektrische Kontakt (6) zwischen der ersten (2) und der zweiten (3) Leiterplatine über die Halterung (4) hergestellt ist, wobei der Kontakt (6) über die Halterung (4) über mindestens ein Kontaktelement (7,24) hergestellt ist, und wobei das Kontaktelement (7,24) die erste Leiterplatine (2) mittels mindestens eines Federelements oder mindestens eines Einpresspins (8) und die zweite Leiterplatine (3) mittels mindestens eines Einpresspins (27) kontaktiert, und dass als Rastverbindungselemente ausgebildete Halteelemente (16) zum Halten der zweiten Leiterplatine (3) an der Halterung (4) vorgesehen sind, wobei die Halterung (4) Einschuböffnungen zur rastenden Aufnahme der Halteelemente (16) aufweist.

2. Elektrische Schaltungsanordnung nach Anspruch 1, **dadurch gekennzeichnet, dass** die vormontierte Einheit (5) mit der ersten Leiterplatine (2) lösbar verbunden ist.

3. Elektrische Schaltungsanordnung nach einem der vorhergehenden Ansprüche, **dadurch gekennzeichnet, dass** die Verbindung zwischen der ersten Leiterplatine (2) und der Halterung (4) und/oder die Befestigung der zweiten Leiterplatine (3) an der Halterung (4) mittels Warmverstemmen, Verschrauben, Verclipsen oder Einpressen hergestellt ist.

4. Elektrische Schaltungsanordnung nach einem der vorhergehenden Ansprüche, **dadurch gekennzeichnet, dass** die Halterung (4) ein Druckgussbauteil ist.

5. Elektrische Schaltungsanordnung nach einem der vorhergehenden Ansprüche, **dadurch gekennzeichnet, dass** die Halterung (4) Aluminium, Zink oder Magnesium oder ein Kunststoff aufweist.

6. Elektrische Schaltungsanordnung nach einem der vorhergehenden Ansprüche, **gekennzeichnet durch** ein Gehäuse (20), in welchem die erste Leiterplatine (2), die zweite Leiterplatine (3) und/oder die Halterung (4) zumindest bereichsweise angeordnet sind.

7. Elektrische Schaltungsanordnung nach einem der vorhergehenden Ansprüche, **dadurch gekennzeichnet, dass** die Halterung (4) zusammen mit der zweiten Leiterplatine (3) an/in dem Gehäuse (20) befestigt ist.

8. Elektrische Schaltungsanordnung nach einem der vorhergehenden Ansprüche, **dadurch gekennzeichnet, dass** die vormontierte Einheit (5) mittels Verschrauben, Verklemmen oder Kleben an/in dem Gehäuse (20) befestigt ist.

9. Elektrische Schaltungsanordnung nach einem der vorhergehenden Ansprüche, **dadurch gekennzeichnet, dass** mindestens zwei Halterungen (4) vorgesehen sind, die unter einem Winkel zueinander angeordnet sind.

10. Steuergerät mit mindestens einer elektrischen Schaltungsanordnung (1) nach einem oder mehreren der vorhergehenden Ansprüche.

11. Verfahren zum Herstellen einer elektrischen Schaltungsanordnung (1) nach einem oder mehreren der vorhergehenden Ansprüche, wobei die Schaltungsanordnung (1) über eine erste Leiterplatine (2), mindestens eine zweite Leiterplatine (3) und mindestens eine Halterung (4) zum Halten der zweiten Leiterplatine (3) an der ersten Leiterplatine (2) unter Herstellung eines elektrischen Kontakts (6) zwischen der ersten (2) und der zweiten (3) Leiterplatine verfügt, wobei die zweite Leiterplatine (3) an der Halterung (4) vormontiert wird und die aus zweiter Leiterplatine (3) und Halterung (4) bestehende vormontierte Einheit (5) mit der ersten Leiterplatine (2) verbunden wird, wobei die Halterung (4) und die zweite Leiterplatine (3) quer, insbesondere rechtwinklig, zu der ersten Leiterplatine (2) angeordnet werden, **dadurch gekennzeichnet, dass** der elektrische Kontakt (6) zwischen der ersten (2) und der zweiten (3) Leiterplatine über die Halterung (4) hergestellt ist, wobei der Kontakt (6) über die Halterung (4) über mindestens ein Kontaktelement (7,24) hergestellt ist, und wobei das Kontaktelement (7,24) die erste Leiterplatine (2) mittels mindestens eines Federelements oder mindestens eines Einpresspins (8) und die zweite Leiterplatine (3) mittels mindestens eines Einpresspins (27) kontaktiert, und dass als Rastverbindungselemente ausgebildete Halteelemente (16) zum Halten der zweiten Leiterplatine (3) an der Halterung (4) vorgesehen sind, wobei die Halterung (4) Einschuböffnungen zur rastenden Aufnahme der Halteelemente (16) aufweist

## Claims

1. Electrical circuit assembly (1) for a control device of a motor vehicle, comprising a first circuit board (2), at least one second circuit board (3) and at least one mount (4) for holding the second circuit board (3) on the first circuit board (2) whilst producing an electrical contact (6) between the first (2) and the second (3) circuit board, wherein the second circuit board (3) is preassembled on the mount (4), and the preassembled unit (5) consisting of second circuit board (3) and mount (4) is connected to the first circuit board (2), wherein the mount (4) and the second circuit board (3) are arranged transversely, in particular at right angles, with respect to the first circuit board (2), **characterized in that** the electrical contact (6) between the first (2) and the second (3) circuit board is produced via the mount (4), wherein the contact (6) via the mount (4) is produced via at least one contact element (7, 24), and wherein the contact element (7, 24) makes contact with the first circuit board (2) by means of at least one spring element or at least one press-fit pin (8) and with the second circuit board (3) by means of at least one press-fit pin (27), and **in that** holding elements (16) embodied as latching connection elements are provided for holding the second circuit board (3) on the mount (4), wherein the mount (4) has insert openings for receiving the holding elements (16) in a latching manner.

2. Electrical circuit assembly according to Claim 1, **characterized in that** the preassembled unit (5) is connected to the first circuit board (2) in a releasable manner.

3. Electrical circuit assembly according to either of the preceding claims, **characterized in that** the connection between the first circuit board (2) and the mount (4) and/or the fixing of the second circuit board (3) to the mount (4) are/is produced by means of hot calking, screwing, clipping or press-fitting.

4. Electrical circuit assembly according to any of the preceding claims, **characterized in that** the mount (4) is a die-cast component.

5. Electrical circuit assembly according to any of the preceding claims, **characterized in that** the mount (4) comprises aluminum, zinc or magnesium or a plastic.

6. Electrical circuit assembly according to any of the preceding claims, **characterized by** a housing (20), in which the first circuit board (2), the second circuit board (3) and/or the mount (4) are arranged at least in regions.

7. Electrical circuit assembly according to any of the preceding claims, **characterized in that** the mount (4) is fixed together with the second circuit board (3) on/in a housing (20).

8. Electrical circuit assembly according to any of the preceding claims, **characterized in that** the preassembled unit (5) is fixed on/in the housing (20) by means of screwing, clamping or adhesive bonding.

9. Electrical circuit assembly according to any of the preceding claims, **characterized in that** at least two mounts (4) are provided, which are arranged at an angle with respect to one another.

10. Control device comprising at least one electrical circuit assembly (1) according to one or more of the preceding claims.

11. Method for producing an electrical circuit assembly (1) according to one or more of the preceding claims, wherein the circuit assembly (1) has a first circuit board (2), at least one second circuit board (3) and at least one mount (4) for holding the second circuit board (3) on the first circuit board (2) whilst producing an electrical contact (6) between the first (2) and the second (3) circuit board, wherein the second circuit board (3) is preassembled on the mount (4), and the preassembled unit (5) consisting of second circuit board (3) and mount (4) is connected to the first circuit board (2), wherein the mount (4) and the second circuit board (3) are arranged transversely, in particular at right angles, with respect to the first circuit board (2), **characterized in that** the electrical contact (6) between the first (2) and the second (3) circuit board is produced via the mount (4), wherein the contact (6) via the mount (4) is produced via at least one contact element (7, 24), and wherein the contact element (7, 24) makes contact with the first circuit board (2) by means of at least one spring element or at least one press-fit pin (8) and with the second circuit board (3) by means of at least one press-fit pin (27), and **in that** holding elements (16) embodied as latching connection elements are provided for holding the second circuit board (3) on the mount (4), wherein the mount (4) has insert openings for receiving the holding elements (16) in a latching manner.

## Revendications

1. Arrangement de circuit électrique (1) pour un contrôleur d'un véhicule automobile, comprenant une première platine à circuit imprimé (2), au moins une deuxième platine à circuit imprimé (3) et au moins un support (4) destiné à maintenir la deuxième platine à circuit imprimé (3) sur la première platine à circuit imprimé (2) en établissant un contact électrique (6) entre la première (2) et la deuxième (3) platine à circuit imprimé, la deuxième platine à circuit imprimé (3) étant prémontée sur le support (4) et l'unité prémontée (5) composée de la deuxième platine à circuit imprimé (3) et du support (4) étant reliée à la première platine à circuit imprimé (2), le support (4) et la deuxième platine à circuit imprimé (3) étant disposés transversalement, notamment à angle droit par rapport à la première platine à circuit imprimé (2), **caractérisé en ce que** le contact électrique (6) entre la première (2) et la deuxième (3) platine à circuit imprimé est établi par le biais du support (4), le contact (6) par le biais du support (4) étant établi par le biais d'au moins un élément de contact (7, 24) et l'élément de contact (7, 24) entrant en contact avec la première platine à circuit imprimé (2) au moyen d'au moins un élément à ressort ou d'au moins une broche à enfoncer (8) et entrant en contact avec la deuxième platine à circuit imprimé (3) par le biais d'au moins une broche à enfoncer (27), et **en ce que** des éléments de maintien (16) réalisés sous la forme d'éléments de liaison à enclenchement sont présents pour maintenir la deuxième platine à circuit imprimé (3) au support (4), le support (4) possédant des ouvertures d'insertion destinées à accueillir avec enclenchement les éléments de maintien (16).

2. Arrangement de circuit électrique selon la revendication 1, **caractérisé en ce que** l'unité prémontée (5) est reliée de manière amovible à la première platine à circuit imprimé (2).

3. Arrangement de circuit électrique selon l'une des revendications précédentes, **caractérisé en ce que** la liaison entre la première platine à circuit imprimé (2) et le support (4) et/ou la fixation de la deuxième platine à circuit imprimé (3) au support (4) est réalisée par matage à chaud, vissage, enclipsage ou enfoncement.

4. Arrangement de circuit électrique selon l'une des revendications précédentes, **caractérisé en ce que** le support (4) est un composant coulé sous pression.

5. Arrangement de circuit électrique selon l'une des revendications précédentes, **caractérisé en ce que** le support (4) possède de l'aluminium, du zinc ou du magnésium ou une matière plastique.

6. Arrangement de circuit électrique selon l'une des revendications précédentes, **caractérisé par** un boîtier (20) dans lequel la première platine à circuit imprimé (2), la deuxième platine à circuit imprimé (3) et/ou le support (4) sont disposés au moins dans certaines zones.

7. Arrangement de circuit électrique selon l'une des revendications précédentes, **caractérisé en ce que** le support (4), conjointement avec la deuxième platine à circuit imprimé (3), est fixé sur/dans le boîtier (20) .

8. Arrangement de circuit électrique selon l'une des revendications précédentes, **caractérisé en ce que** l'unité prémontée (5) est fixée sur/dans le boîtier (20) par vissage, calage ou collage.

9. Arrangement de circuit électrique selon l'une des revendications précédentes, **caractérisé en ce qu'**il existe au moins deux supports (4) qui sont disposés selon un angle donné l'un par rapport à l'autre.

10. Contrôleur comprenant au moins un arrangement de circuit électrique (1) selon l'une ou plusieurs des revendications précédentes.

11. Procédé de fabrication d'un arrangement de circuit électrique (1) selon l'une ou plusieurs des revendications précédentes, l'arrangement de circuit (1) disposant d'une première platine à circuit imprimé (2), d'au moins une deuxième platine à circuit imprimé (3) et d'au moins un support (4) destiné à maintenir la deuxième platine à circuit imprimé (3) sur la première platine à circuit imprimé (2) en établissant un contact électrique (6) entre la première (2) et la deuxième (3) platine à circuit imprimé, la deuxième platine à circuit imprimé (3) étant prémontée sur le support (4) et l'unité prémontée (5) composée de la deuxième platine à circuit imprimé (3) et du support (4) étant reliée à la première platine à circuit imprimé (2), le support (4) et la deuxième platine à circuit imprimé (3) étant disposés transversalement, notamment à angle droit par rapport à la première platine à circuit imprimé (2), **caractérisé en ce que** le contact électrique (6) entre la première (2) et la deuxième (3) platine à circuit imprimé est établi par le biais du support (4), le contact (6) par le biais du support (4) étant établi par le biais d'au moins un élément de contact (7, 24) et l'élément de contact (7, 24) entrant en contact avec la première platine à circuit imprimé (2) au moyen d'au moins un élément à ressort ou d'au moins une broche à enfoncer (8) et entrant en contact avec la deuxième platine à circuit imprimé (3) par le biais d'au moins une broche à enfoncer (27), et **en ce que** des éléments de maintien (16) réalisés sous la forme d'éléments de liaison à enclenchement sont présents pour maintenir la deuxième platine à circuit imprimé (3) au support (4), le support (4) possédant des ouvertures d'insertion destinées à accueillir avec enclenchement les éléments de maintien (16).
